Europäisches Patentamt

European Patent Office

Office européen des brevets

(19)

(11) Veröffentlichungsnummer: **0 039 428**
**B1**

(12) **EUROPÄISCHE PATENTSCHRIFT**

(45) Veröffentlichungstag der Patentschrift:
23.03.83

(51) Int. Cl.³: **H 04 B 12/02,** H 03 G 3/34

(21) Anmeldenummer: 81102832.3

(22) Anmeldetag: 13.04.81

(54) Knackschutz für die digitale Tonprogrammübertragung.

(30) Priorität: 30.04.80 DE 3016779

(43) Veröffentlichungstag der Anmeldung:
11.11.81 Patentblatt 81/45

(45) Bekanntmachung des Hinweises auf die Patenterteilung:
23.03.83 Patentblatt 83/12

(84) Benannte Vertragsstaaten:
AT BE CH FR GB IT LI LU NL SE

(56) Entgegenhaltungen:
GB-A-2 007 945
RUNDFUNKTECHNISCHE MITTEILUNGEN,
Band 24, Nr. 1, Januar 1980, Seiten 31—36
Hamburg, DE. W. THOMA: »Digitale Tonprogrammübertragung über 2048-KBIT/S-Verbindungen«.

(73) Patentinhaber: SIEMENS AKTIENGESELLSCHAFT,
Berlin und München Wittelsbacherplatz 2,
D-8000 München 2 (DE)

(72) Erfinder: Pexa, Günther, Brückenweg 2A,
D-8031 Wörthsee (DE)

## Knackschutz für die digitale Tonprogrammübertragung

Die Erfindung betrifft eine Schaltungsanordnung zur Vermeidung von Knackgeräuschen bei der digitalen Tonprogrammübertragung.

Bei der digitalen Tonprogrammübertragung kommt es durch Störungen auf der Übertragungsstrecke zu Verfälschungen der digitalisierten Nachricht. Diese Verfälschungen machen sich, besonders wenn die höherwertigen Bits betroffen sind, als unangenehme Knackgeräusche bemerkbar.

In der Zeitschrift telcom report (1979), Beiheft »Digital-Übertragungstechnik«, Seiten 52 bis 58, wird ein PCM-Tonkanalsystem beschrieben. Bei der Pulscodemodulation wird bekanntlich einem bestimmten analogen Abtastwert ein entsprechender Zahlenwert eines Codewortes zugeordnet. Einer großen Amplitude des Abtastwertes entspricht ein großer Zahlenwert. Zur Verbesserung des Geräuschabstandes wird das Tonprogrammsignal sendeseitig mit einem Preemphasisnetzwerk verzerrt und empfangsseitig mit einem entsprechenden Deemphasisnetzwerk entzerrt. Vor der Übertragung wird das preemphasierte Tonprogrammsignal digitalisiert und einem Digitalkompressor zugeführt. Dieser vermindert die Gesamtzahl der Quantisierungsintervalle und damit die notwendige Wortlänge. Die Größe der Intervalle bleibt bei kleinen Abtastwerten unverändert, bei großen Abtastwerten wird die Größe der Intervalle entsprechend erhöht. Hierdurch ergibt sich für größere Abtastwerte eine nahezu logarithmische Kennlinie. Die gesamte Umsetzungskennlinie wird als arithmetisch-logarithmisch bezeichnet, sie entspricht dem 11-Segment- oder 13-Segment-Kompandergesetzt. Das Vermindern der Wortlänge wird auf der Empfangsseite durch einen Digitalexpander wieder rückgängig gemacht. Bitfehler beim Übertragen der Codewörter führen zur Wiedergabe falscher Abtastwerte auf der Empfangsseite. Die verfälschte Übertragung eines oder mehrerer der fünf höchstwertigen Bits der Codewörter kann zu einem hörbaren Knack bei der Wiedergabe führen. Dieser Effekt ist bei Fehlern der geringerwertigen Bits hingegen vernachlässigbar. Eine Schutzmaßnahme gegen Knackstörungen besteht beim beschriebenen Tonkanalsystem darin, daß bei einer Fälschung der fünf höchstwertigen Bits das gestörte Codewort durch das letzte richtige ersetzt wird. Sind mehrere aufeinanderfolgende Abtastproben fehlerhaft, wird das Tonprogramm kurzzeitig »weich« ausgeschaltet. In der CCIR-Mitteilung Doc. CMTT/4-E 19. November 1975 wird auf Seite 7, Abschnitt 7.2 vorgeschlagen, das Empfangssignal exponentiell zu verringern, um ein Minimum an störenden Geräuschen zu erhalten.

In der Zeitschrift »Rundfunktechnische Mitteilungen«, Vol. 24 (1980) Jan. Heft 1, Seiten 31 – 36 werden Regeln für das Abschalten bei Störungen und das erneute Einschalten bei kleinen Pegeln aufgestellt.

Die praktische Realisierung dieser Forderung ist jedoch mit erheblichem technischen Aufwand verbunden.

Aufgabe der Erfindung ist es, eine einfache, mit geringem Aufwand realisierbare Schaltungsanordnung anzugeben, die bei der digitalen Tonprogrammübertragung die durch Verfälschungen der Codewörter verursachten Knackgeräusche vermindert.

Die Aufgabe wird dadurch gelöst, daß ein mehrstufiger erster digitaler Speicher mit n Kippstufen je Bit eines Codewortes vorgesehen ist, dem das empfangene komprimierte digitale Codewort über Schaltungseingänge parallel zugeführt ist, daß die höherwertigen Bits des digitalen Empfangssignals und das Vorzeichenbit an eine Paritätsprüfung angeschlossen sind, daß der erste Ausgang des ersten Speichers, an dem das Vorzeichenbit abgegeben wird, und die Ausgänge, an denen die niederwertigen Bits abgegeben werden, mit den Eingängen eines für jedes Bit nur ein Speicherglied enthaltenden zweiten Speichers angeschlossen sind, daß die höherwertigen Ausgänge an die Paralleleingänge eines voreinstellbaren binären Rückwärtszählers angeschlossen sind, daß die Ausgänge des zweiten Speichers und die Ausgänge des Binärzählers an Anschlußpunkte geführt sind, die den Schaltungseingängen entsprechen, daß diese Ausgänge an einen Expanderteil angeschlossen sind, daß eine Steuerung vorgesehen ist, deren Takteingang mit dem Takteingang des ersten Speichers verbunden ist, daß ein zweiter Eingang der Steuerung an den Ausgang der Paritätsprüfung angeschlossen ist, daß der Ausgang eines an die höherwertigsten Ausgänge des ersten Speichers angeschlossenen NOR-Gatters mit einem vierten Eingang der Steuerung und der Übertragungsausgang des Binärzählers an einen dritten Eingang der Steuerung angeschaltet ist, daß ein erster Taktausgang der Steuerung an den Takteingang des zweiten Speichers und an den Übernahmetakteingang des Binärzählers angeschlossen ist und daß ein zweiter Taktausgang der Steuerung auf den Zähltakteingang des Binärzählers geführt ist.

Diese Schaltung zeichnet sich durch einfache Realisierbarkeit aus. Die Schaltung ist mit wenigen integrierten Bausteinen realisierbar.

Es ist vorteilhaft, daß die Steuerung ein Schieberegister enthält, das aus mindestens so vielen Kippstufen besteht, wie im ersten Speicher Speicherplätze für jedes Bit vorgesehen sind, daß der Eingang des Schieberegisters an den Ausgang der Paritätsprüfung angeschlossen ist, daß dem Schieberegister über den Takteingang der Worttakt zugeführt ist, daß die Ausgänge der Kippstufen des Schieberegisters an eine Schwellwertlogik angeschlossen sind, die ein Fehlersignal abgibt, wenn das am Ausgang des ersten Speichers liegende Codewort und an mindestens einem weiteren Eingang der Schwellwertlogik ein Paritätsfehlersignal anliegt, daß der Ausgang der Schwellwertlogik über ein erstes UND-Gatter auf den Setzeingang einer Steuerkippstufe geführt ist, daß der zweite Eingang des ersten UND-Gatters über einen ersten Inverter mit dem Takteingang verbunden ist, daß der Q-Ausgang der Steuerkippstufe mit einem ersten Eingang eines zweiten UND-Gatters verbunden ist, dessen zweiter Eingang über einen zweiten Inverter mit dem dritten Eingang der Steuerung und dessen dritter Eingang mit einem ersten Eingang eines dritten UND-Gatters und dem Takteingang verbunden ist, daß der invertierende Ausgang der Steuerkippstufe mit einem zweiten Eingang des dritten UND-Gatters verbunden ist, dessen dritter Eingang an den invertierenden Ausgang einer als Verzögerungsglied dienenden D-Kippstufe angeschlossen ist, deren D-Eingang an den Ausgang der n-ten Kippstufe des Schieberegisters angeschlossen ist und deren Takteingang an den Ausgang des ersten Inverters angeschlossen ist, daß der Ausgang des zweiten UND-Gatters auf den zweiten Taktausgang geführt ist, daß der Ausgang des dritten UND-Gatters auf den ersten Taktausgang geführt ist, daß ein zweites NOR-Gatter vorgesehen ist, dessen Eingänge mit allen Ausgängen der Kippstufen des Schieberegisters verbunden sind und daß der Ausgang des zweiten NOR-Gatters auf den zweiten Eingang eines vierten UND-Gatters geführt ist, dessen erster Eingang an den Ausgang des ersten Inverters angeschaltet ist, dessen dritter Eingang auf den vierten Eingang der Steuerung, dessen vierter Eingang mit dem dritten Eingang der Steuerung und dessen Ausgang mit dem Rücksetzeingang der Steuerkippstufe verbunden ist.

Auch die Steuerung kann aus diskreten Bausteinen aufgebaut werden. Die Steuerung ist, wie die gesamte Schaltungsanordnung, auch in monolithischer Integration herstellbar.

Weitere Ausbildungen der Erfindung sind in den Unteransprüchen angegeben.

Es zeigen

Fig. 1 eine Schaltungsanordnung gemäß der Erfindung,

Fig. 2 eine Schaltungsanordnung der Steuerung nach Fig. 1 und

Fig. 3 ein Zeitdiagramm der Steuerung.

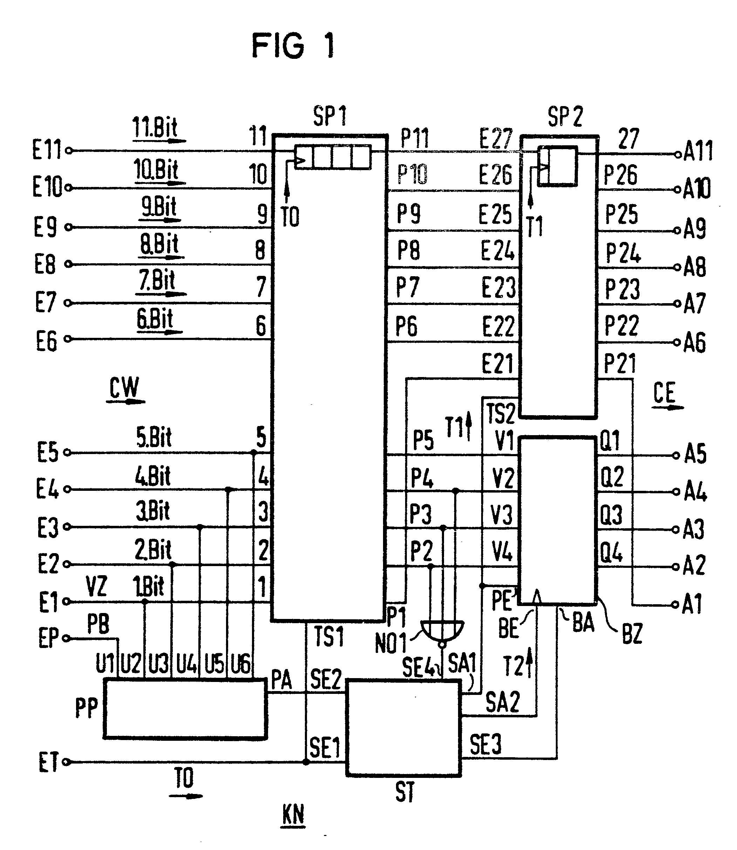

Die erfindungsgemäße Schaltungsanordnung einer Knackschutzschaltung KN ist in der Fig. 1 dargestellt. Über die Eingänge E1 bis E11 der Knackschutzschaltung KN werden einem ersten Speicher SP1 mit den Eingängen 1 bis 11 die 11 Information enthaltenden Bits der übertragenen Codewörter zugeführt. Das erste Bit, das Vorzeichenbit VZ, ist dabei auf den Eingang 1 des ersten Speichers SP1 geführt, das elfte Bit auf den Eingang 11. Die Schaltungseingänge E1 bis E5 sind außerdem mit den Eingängen U2 bis U6 einer Paritätsprüfung verbunden. Der erste Eingang U1 der Paritätsprüfung PP ist mit dem Schaltungseingang EP verbunden, an dem das zwölfte Bit eines Codewortes, das Paritätsbit PB, anliegt. Der erste Speicher SP1 enthält für jedes Bit vier binäre Speicherelemente. Für das elfte Bit, das heißt für den Eingang 11 des ersten Speichers SP1, wurden diese Speicherelemente durch vier Quadrate symbolisch dargestellt. Der Ausgang des vierten Speicherelementes führt auf den Ausgang P11. Die weiteren Ausgänge des ersten Speichers SP1 sind den Eingängen 1 bis 10 entsprechend mit P1 bis P10 bezeichnet. Die Ausgänge P6 bis P11 sind mit den Eingängen E22 bis E27 eines zweiten Speichers SP2 verbunden, der erste Ausgang P1 des ersten Speichers SP1 ist mit dem ersten Eingang E21 des zweiten Speichers SP2 verbunden. Der zweite Speicher SP2 enthält nur sieben binäre Speicherelemente, von denen nur eines symbolisch dargestellt ist. Den Eingängen E22 bis E27 des zweiten Speichers entsprechen seine Ausgänge P22 bis P27, bzw. die Anschlußpunkte A6 bis A11, an denen die niederwertigsten Bits, das sechste bis elfte Bit abgegeben werden. Dem ersten Eingang E21 des zweiten Speichers SP2 entspricht der Ausgang P21 bzw. der Anschlußpunkt A1, an dem ein Vorzeichenbit abgegeben wird. Die Ausgänge P5 bis P2 des ersten Speichers SP1 sind jeweils mit Eingängen V1 bis V4 eines Binärzählers BZ verbunden. Den Eingängen V1 bis V4 entsprechen die Ausgänge Q1 bis Q4 des Binärzählers BZ, die Ausgänge Q4 bis Q1 sind auf die Anschlußpunkte A2 bis A5 geführt. Am Anschlußpunkt A2 liegt demnach das höchstwertigste Bit (Q4) an, am Anschlußpunkt A1 das Vorzeichenbit, die Ausgänge A1 bis A11 entsprechen damit den Eingängen E1 bis E11. Bei dem Binärzähler BZ handelt es sich um einen handelsüblichen Baustein, einen sogenannten Abwärtszähler. Es kann jedoch ebenso ein Aufwärts-Abwärts-Zähler verwendet werden, der fest auf Abwärtszählen geschaltet wurde.

Über einen Schaltungseingang ET wird einer Steuerung ST über deren Takteingang SE1 ein Worttakt TO zugeführt. Der Takteingang SE1 ist mit einem Takteingang TS1 des ersten Speichers SP1 verbunden. Ein Paritätsfehler-Ausgang PA der Paritätsprüfung PP ist an einen zweiten Eingang SE2 der Steuerung ST angeschlossen, ein erster Taktausgang SA1 der Steuerung ST ist mit einem Übernahmetakt-Eingang PE des Binärzählers BZ und mit einem Takteingang TS2 des zweiten Speichers SP2 verbunden. Ein zweiter Taktausgang SA2 der Steuerung ST ist mit einem Zähltakteingang BE des Binärzählers BZ verbunden; der Übertragsausgang BA des Binärzählers BZ ist auf einen dritten Eingang SE3 der Steuerung ST geführt. Drei Eingänge eines ersten NOR-Gatters NO1 sind mit den Ausgängen P2, P3 und P4 des ersten Speichers SP1 verbunden, der Ausgang des NOR-Gatters NO1 ist auf einen vierten Eingang SE4 der Steuerung ST geführt.

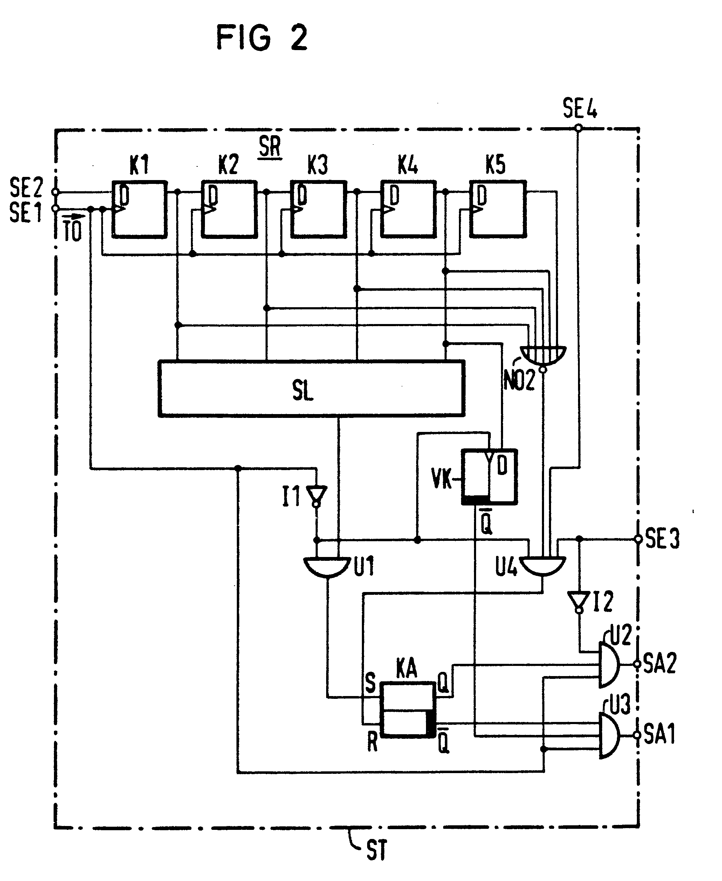

Die Steuerung ST ist in Figur 2 dargestellt. Sie enthält ein fünfstufiges Schieberegister SR. Der D-Eingang der ersten Kippstufe K1 ist mit dem zweiten Eingang SE2 der Steuerung verbunden. Die Takteingänge der Kippstufe K1 bis K5 des Schieberegisters sind mit dem Takteingang SE1 verbunden. Die Ausgänge der ersten bis vierten Kippstufe K1 bis K4 sind an eine Schwellwertlogik SL angeschlossen. Sie sind außerdem mit vier Eingängen eines zweiten NOR-Gatters NO2 verbunden, dessen fünfter Eingang an den Ausgang der fünften Kippstufe K5 angeschlossen ist. Die Schwellwertlogik SL besteht aus einer einfachen Gatterschaltung, sie gibt an ihrem Ausgang dann eine logische 1 ab, wenn der Ausgang der vierten Kippstufe K4 und zwei weitere Ausgänge der Kippstufen K1 bis K3 eine logische Eins abgeben. Der Ausgang der Schwellwertlogik ist auf einen ersten Eingang eines ersten UND-Gatters U1 geführt; der zweite Eingang dieses UND-Gatters ist über einen ersten Inverter I1 mit dem Eingang SE1 verbunden. Der Ausgang des ersten UND-Gatters U1 führt auf einen Setzeingang S einer Steuerkippstufe KA. Der Rücksetzeingang R dieser Kippstufe ist mit dem Ausgang eines vierten UND-Gatters U4 verbunden. Der erste Eingang dieses UND-Gatters U4 ist mit dem Ausgang des ersten Inverters I1 verbunden, der zweite Eingang ist mit dem Ausgang des zweiten NOR-Gatters NO2 verbunden, der dritte Eingang ist mit dem vierten Eingang SE4 und der vierte Eingang ist mit dem dritten Eingang SE3 der Steuerung verbunden.

Der Q-Ausgang der Steuerkippstufe KA ist mit einem ersten Eingang eines zweiten UND-Gatters U2 verbunden, dessen zweiter Eingang über einen zweiten Inverter I2 ebenfalls mit dem dritten Eingang SE3 der Steuerung ST verbunden und dessen dritter Eingang mit einem ersten Eingang eines dritten UND-Gatters U3 sowie mit dem ersten Eingang SE1 der Steuerung verbunden ist. Der Ausgang des zweiten UND-Gatters U2 entspricht dem zweiten Taktausgang SA2 der Steuerung. Der zweite Eingang des dritten UND-Gatters U3 ist mit dem Ausgang Q̄ der Steuerkippstufe KA verbunden, und ein dritter Eingang des dritten UND-Gatters U3 ist an den Q̄-Ausgang einer als Verzögerungsglied wirkenden Kippstufe VK angeschlossen. Der D-Eingang der Verzögerungskippstufe VK ist mit dem Ausgang der vierten Kippstufe K4 verbunden. Der Takteingang der Verzögerungskippstufe VK ist an den Ausgang des ersten Inverters I1 angeschlossen. Der Ausgang des dritten UND-Gatters U3 entspricht dem ersten Taktausgang SA1 der Steuerung ST.

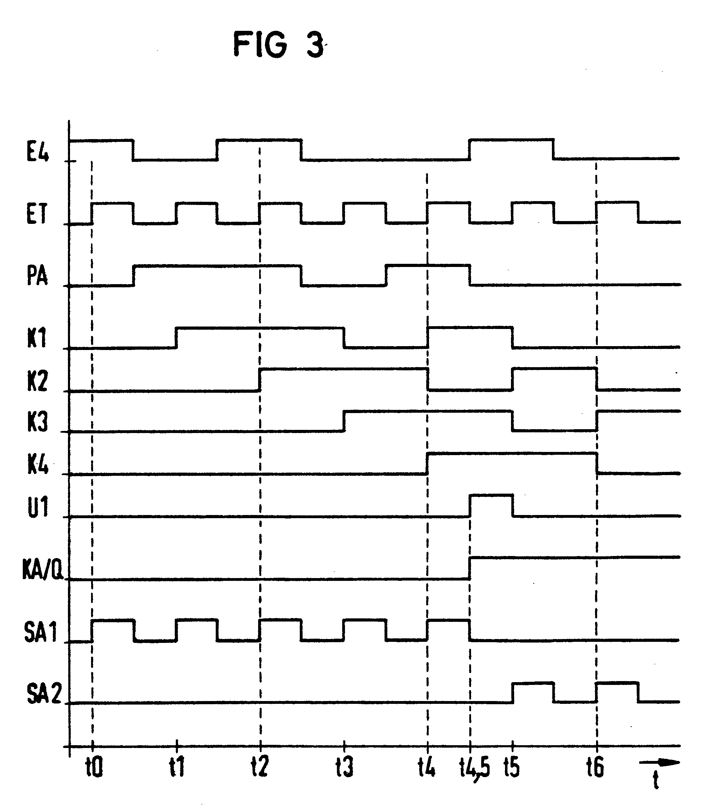

In Figur 3 ist ein Zeitdiagramm der Steuerung ST dargestellt. Die Spannungsverläufe an den angegebenen Punkten entsprechen logischen Signalen. Das höhere Potential entspricht dabei der logischen Eins.

Die empfangenen Codewörter werden zuerst in einem nicht dargestellten Empfangsteil in eine parallele Form überführt. Das erste Bit, das Vorzeichenbit VZ und zehn weitere Bits liegen an den Eingängen E1 bis E11 der Knackschutzschaltung KN und damit an den Eingängen 1 bis 11 des ersten Speichers SP1 an. Das Paritätsbit PB wird über den Eingangspunkt EP auf einen ersten Eingang der Paritätsprüfung PP geführt, die Bits 1 bis 5 sind auf weitere fünf Eingänge der Paritätsprüfung PP geschaltet. Die einzelnen Codewörter werden in den ersten Speicher SP1 mit dem am Takteingang TS1 anliegenden Worttakt TO eingeschrieben und zeitlich verzögert nach vier Taktimpulsen TO an den Ausgängen P1 bis P11 wieder ausgegeben. Die niederwertigsten Bits, das sechste bis elfte Bit, wie auch das Vorzeichenbit VZ werden in den zweiten Speicher SP2 eingeschrieben. Dies geschieht mit einem Takt T1, der dem am Eingang ET anliegenden Worttakt To entspricht. Die höherwertigen Bits, das zweite bis fünfte Bit werden dazu benutzt, den Binärzähler BZ in eine der Kombination des zweiten bis fünften Bits entsprechende Anfangsstellung bringen. Dies geschieht mit demselben Takt T1. Das fünfte Bit bestimmt dabei die niederwertigste Stelle Q1 des Binärzählers BZ, das zweite Bit bestimmt die höchstwertige Stelle Q4 des Binärzählers BZ. Der Binärzähler BZ ist, wie bereits erwähnt, ein handelsüblicher Baustein. Die Eingänge V1 bis V4 entsprechen den Setzeingängen.

Mit dem Impuls T1 am Eingang PE (preset enable) wird die an den Eingängen V1 bis V4 anliegende Information übernommen. Der Binärzähler BZ arbeitet somit zunächst als digitaler Speicher. Dem Takteingang BE darf während dieser Funktionsweise kein Zähltakt T2 zugeführt werden. Ein an den Eingängen E1 bis E11 anliegendes Codewort CW wird demnach nach fünf Taktimpulsen TO an den Ausgängen A1 bis A11, jetzt mit CE bezeichnet, abgegeben und einem digitalen Expander zugeführt.

Bei der Schaltungsanordnung ist noch vorausgesetzt, daß alle Kippstufen mit der positiven Flanke getriggert werden. Sind die höherwertigen fünf Bits, die Bits 1 bis 5 eines Codewortes richtig empfangen worden, so gibt die Paritätsprüfung PP an ihrem Paritätsfehler-Ausgang PA die logische Null ab (t0, Fig. 4). Ist dagegen eines der fünf höherwertigen Bits gestört, so gibt die Paritätsprüfung PP an ihren Paritätsfehler-Ausgang die logische Eins ab (t1). Diese logische Eins wird in die erste Kippstufe K1 des Schieberegisters SR der Steuerung ST übernommen. Es wird angenommen, daß auch das nächste und das vierte Codewort gestört sind. Zu dem Zeitpunkt t2 und zu dem Zeitpunkt t4 werden weitere logische Einsen in das Schieberegister SR übernommen. Ab dem Zeitpunkt t4 befinden sich daher die Ausgänge der ersten Kippstufe K1, der dritten Kippstufe K3 und der vierten Kippstufe K4 des Schieberegisters SR auf der logischen Eins. Über die Verzögerungskippstufe VK wird das dritte UND-Gatter U3 gesperrt (t4, 5). Dadurch bleibt das letzte ungestörte Codewort im Speicher SP2 bzw. im Binärzähler BZ erhalten. Wäre das erste gestörte Codewort das einzige geblieben, so würde mit der nächsten positiven Flanke des Taktes TO das nächste Codewort an die Ausgänge A1 bis A11 weitergegeben werden. Da jedoch außer diesem ersten Codewort zwei weitere gestört sind, gibt die Schwellwertlogik SL an ihrem Ausgang die Eins ab. Damit wird die Steuerkippstufe KA über ihren Setzeingang S eingestellt. Das dritte UND-Gatter U3 bleibt gesperrt, es werden keine weiteren Codewörter aus dem Speicher SP1 in den Speicher SP2 übernommen. Dafür wird das zweite UND-Gatter U2 freigegeben, der Binärzähler BZ erhält daher an seinem Takteingang BE über das zweite UND-Gatter U2 einen Zähltakt T2, der zeitgemäß dem Takt T0 entspricht. Mit jeder positiven Taktflanke T2 wird sein Inhalt um einen Binärwert vermindert, bis er an seinem Übertragsausgang BA beim Zählerstand Null die Eins abgibt. Damit wird das zweite UND-Gatter U2 gesperrt und somit erhält er auch keinen Zähltakt T2 mehr. Die lineare Verminderung des Anfangswertes des Binärzählers BZ entspricht einer exponentiellen Verminderung des expandierten Wertes des Codewortes und damit des akustischen Signales. Hierbei ist es nicht notwendig, die niederwertigen Bits, das sechste bis elfte Bit, zu beachten. Nachdem mindestens fünf richtige Codewörter hintereinander empfangen worden sind, dadurch daß zweite NOR-Gatter NO2 an seinem Ausgang die Eins abgibt und ein kleiner Abtastwert am Ausgang des ersten Speichers SP1 anliegt, wird die Steuerkippstufe KA über den Rücksetzeingang R zurückgesetzt. Der geforderte kleine absolute Wert des am Ausgang des ersten Speichers SP1 anliegenden Codewortes wird durch das erste NOR-Gatter NO1 überprüft. Die ersten drei höherwertigen Bits, das 2. bis 4. Bit, müssen Null sein. Dadurch ist sichergestellt, daß die Differenz zwischen dem an den Expander abgegebenen Codewort und dem folgenden und mit dem nächsten Takt T1 an den Expander weiterzuschaltenden Codewort gering ist. Hierdurch wird ein Knackgeräusch beim Einschalten vermieden.

Die angegebene Schaltung eignet sich für eine Übertragungsgeschwindigkeit von 384 kbit/s. Diese entspricht einer Übertragungsrate von 32 000 Codewörtern pro Sekunde und damit einem Worttakt T0 von 32 kHz.

## Patentansprüche

1. Schaltungsanordnung zur Vermeidung von Knackgeräuschen bei der digitalen Tonprogrammübertragung, dadurch gekennzeichnet, daß ein mehrstufiger erster digitaler Speicher (SP1) mit n Kippstufen je Bit eines Codewortes (n = Anzahl der zwischengespeicherten Codewörter) vorgesehen ist, dem das empfangene komprimierte digitale Codewort (1. Bit bis 11. Bit) über Schaltungseingänge (E1 bis E11) parallel zugeführt ist, daß die höherwertigen Bits (2. Bit bis 5. Bit) des digitalen Empfangssignals und das Vorzeichenbit (VZ) an eine Paritätsprüfung (PP) angeschlossen sind, daß der erste Ausgang (P1) des ersten Speichers (SP1), an dem das nächste Codewort abgegeben wird, und die Ausgänge (P6 bis P11), an denen die niederwertigen Bits abgegeben werden, mit den Eingängen (E22 bis E27) eines für jedes Bit nur ein Speicherglied enthaltenden zweiten Speichers (SP2) angeschlossen sind, daß die höherwertigen Ausgänge (P5 bis P2) an die Paralleleingänge (V1 bis V4) eines voreinstellbaren binären Rückwärtszählers (BZ) angeschlossen sind, daß die Ausgänge (P21 bis P27) des zweiten Speichers (SP2) und die Ausgänge (Q1 bis Q4) des Binärzählers (BZ) an Anschlußpunkte (A1 bis A11) geführt sind, die den Schaltungseingängen (E1 bis E11) entsprechen (A1 entspricht E1), daß diese Ausgänge (A1 bis A11) an einen Expanderteil angeschlossen sind, daß eine Steuerung (ST) vorgesehen ist, deren Takteingang (SE1) mit dem Takteingang (TS1) des ersten Speichers (SP1) verbunden ist, daß ein zweiter Eingang (SE2) der Steuerung an den Ausgang (PA) der Paritätsprüfung (PP) angeschlossen ist, daß der Ausgang eines an die höherwertigsten Ausgänge (P2 bis P4) des ersten Speichers (SP1) angeschlossenen NOR-Gatters (NO1) mit einem vierten Eingang (SE4) der Steuerung (ST) und der Übertragungsausgang (Borrow — BA) des Binärzählers (BZ) an einen dritten Eingang (SE3) der Steuerung (ST) angeschaltet ist, daß ein erster Taktausgang (SA1) der Steuerung (ST) an den Takteingang (TS2) des zweiten Speichers (SP2) und an den Übernahmetakteingang (PE) des Binärzählers (BZ) angeschlossen ist und daß ein zweiter Taktausgang (SA2) der Steuerung (ST) auf den Zähltakteingang (BE) des Binärzählers (BZ) geführt ist.

2. Schaltungsanordnung nach Anspruch 1, dadurch gekennzeichnet, daß die Steuerung (ST) ein Schieberegister (SR) enthält, das aus mindestens so vielen Kippstufen (n) besteht, wie im ersten Speicher (SP1) Speicherplätze (n) für jedes Bit vorgesehen sind, daß der Eingang (SE2) des Schieberegisters (SR) an den Ausgang (PA) der Paritätsprüfung (PP) angeschlossen ist, daß dem Schieberegister (SR) über den Takteingang (SE1) der Worttakt (TO) zugeführt ist, daß die Ausgänge der Kippstufen (K1 bis K4) des Schieberegisters (SR) an eine Schwellwertlogik (SL) angeschlossen sind, die ein Fehlersignal abgibt, wenn das am Ausgang des ersten Speichers (SP1) liegende Codewort und an mindestens einem weiteren Eingang der Schwellwertlogik (SL) ein Paritätsfehlersignal anliegt, daß der Ausgang der Schwellwertlogik (SL) über ein erstes UND-Gatter (U1) auf den Setzeingang (S) einer Steuerkippstufe (KA) geführt ist, daß der zweite Eingang des ersten UND-Gatters (U1) über einen ersten Inverter (I1) mit dem Takteingang (SE1) verbunden ist, daß der Q-Ausgang der Steuerkippstufe (KA) mit einem ersten Eingang eines zweiten UND-Gatters (U2) verbunden ist, dessen zweiter Eingang über einen zweiten Inverter (I2) mit dem dritten Eingang (SE3) der Steuerung (ST) und dessen dritter Eingang mit einem ersten Eingang eines dritten UND-Gatters (U3) und dem Takteingang (SE1) verbunden ist, daß der invertierende Ausgang ($\overline{Q}$) der Steuerkippstufe (KA) mit einem zweiten Eingang des dritten UND-Gatters (U3) verbunden ist, dessen dritter Eingang an den invertierenden Ausgang ($\overline{Q}$) einer als Verzögerungsglied dienenden D-Kippstufe (VK) angeschlossen ist, deren D-Eingang an den Ausgang der n-ten Kippstufe (K4) des Schieberegisters (SR) angeschlossen ist und deren Takteingang an den Ausgang des ersten Inverters (I1) angeschlossen ist, daß der Ausgang des zweiten UND-Gatters (U2) auf den zweiten Taktausgang (SA2) geführt ist, daß der Ausgang des dritten UND-Gatters (U3) auf den ersten Taktausgang (SA1) geführt ist, daß ein zweites NOR-Gatter (NO2) vorgesehen ist, dessen Eingänge mit allen Ausgängen der Kippstufen (K1 bis K5) des Schieberegisters (SR) verbunden sind und daß der Ausgang des zweiten NOR-Gatters (NO2) auf den zweiten Eingang eines vierten UND-Gatters (U4) geführt ist, dessen erster Eingang an den Ausgang des ersten Inverters (I) angeschaltet ist, dessen dritter Eingang auf den vierten Eingang (SE4) der Steuerung (ST), dessen vierter Eingang mit dem dritten Eingang (SE3) der Steuerung (ST) und dessen Ausgang mit dem Rücksetzeingang (R) der Steuerkippstufe (KA) verbunden ist.

3. Schaltungsanordnung nach Anspruch 1, dadurch gekennzeichnet, daß bei einer Übertragungsrate von 32 000 Codewörtern je Sekunde der erste Speicher (SP1) eine Speicherkapazität von n = 4 Bits je Informationsbit (VZ, 2. bis 11. Bit) eines Codewortes besitzt.

4. Schaltungsanordnung nach einem der vorhergehenden Ansprüche, dadurch gekennzeichnet, daß ein Schieberegister (SR) mit n + 1 Kippstufen vorgesehen ist.

5. Schaltungsanordnung nach einem der vorhergehenden Ansprüche, dadurch gekennzeichnet, daß ein vierstufiger Binärzähler (BZ) vorgesehen ist.

6. Schaltungsanordnung nach einem der Ansprüche 1 bis 3, dadurch gekennzeichnet, daß die drei höchstwertigen Bits (2. bis 4. Bit) auf die Eingänge des ersten NOR-Gatters (NO1) angeschaltet sind.

7. Schaltungsanordnung nach einem der vorhergehenden Ansprüche, dadurch gekennzeichnet, daß die Schaltungsanordnung in einer monolithischen Integrationstechnik ausgeführt ist.

## Claims

1. Circuit arrangement for avoiding clicking noise in the digital sound programme transmission, characterised in that there is provided a multi-stage first digital store (SP1) which has n flip-flops for each bit of a code word (n = number of the temporarily stored code words) and to which the received compressed digital code word (1st bit to 11th bit) is supplied in parallel via circuit inputs (E1 to E11), that the higher-level bits (2nd bit to 5th bit) of the digital received signal and the sign bit (VZ) are connected to a parity check (PP), that the first output (P1) of the first store (SP1), at which the sign bit is emitted, and the outputs (P6 to P11), at which the low-level bits are emitted, are connected to the inputs (E22 to E27) of a second store (SP2) which contains only one storage element for each bit, that the higher-level outputs (P5 to P2) are connected to the parallel inputs (V1 to V4) of a presettable binary countdown counter (BZ), that the outputs (P21 to P27) of the second store (SP2) and the outputs (Q1 to Q4) of the ninary counter (BZ) are led to the terminal points (A1 to A11) which correspond to the circuit inputs (E1 to E11) (A1 corresponds to E1), that these outputs (A1 to A11) are connected to an expander section, that there is provided a control unit (ST) whose pulse input (Se1) is connected to the pulse input (TS1) of the first store (SP1), that a second input (SE2) of the control unit is connected to the output (PA) of the parity check (PP), that the output of a NOR-Gate (NO1), which is connected to the higher-level outputs (P2 to P4) of the first store (SP1), is connected to a fourth input (SE4) of the control unit (ST) and the transmission output (Borrow — BA) of the binary counter (BZ) is connected to a third input (SE3) of the control unit (ST), that a first pulse output (SA1) of the control unit (ST) is connected to the pulse input (TS2) of the second store (SP2) and to the transfer pulse input (PE) of the binary counter (BZ), and that a second pulse output (SA2) of the control unit (ST) is connected to the counting pulse input (BE) of the binary counter (BZ).

2. Circuit arrangement as claimed in claim 1, characterised in that the control unit (ST) contains a shift register (SR) which comprises at least as many flip-flops (n) as storage places (n) are provided for each bit in the first store (SP1), that the input (SE2) of the shift register (SR) is connected to the output (PA) of the parity check (PP), that the shift register (SR) is fed with the word pulse (TO) via the pulse input (SE1), that the outputs of the flip-flops (K1 to K4) of the shift register (SR) are connected to threshold logic (SL) which emits a fault signal when the code word which is present at the output of the first store (SP1) and, to at least one further input of the threshold logic (SL), a parity fault signal is connected, that the output of the threshold logic (SL) is connected via a first AND-gate (U1) to the setting input (S) of a control flip-flop (KA), that the second input of the first AND-gate (U1) is connected via a first inverter (I1) to the pulse input (SE1), that the Q-output of the control flip-flop (KA) is connected to a first input of a second AND-gate (U2) whose second input is connected via a second inverter (I2) to the third input (SE3) of the control unit (ST) and whose third input is connected to a first input of a third AND-gate (U3) and to the pulse input (SE1), that the inverting output ($\overline{Q}$) of the control flip-flop (KA) is connected to a second input of the third AND-gate (U3) whose third input is connected to the inverting output ($\overline{Q}$) of a D-flip-flop (VK) which serves as a delay element and whose D-input is connected to the output of the nth flip-flop (K4) of the shift register (SR) and whose pulse input is connected to the output of the first inverter (I1), that the output of the second AND-gate (U2) is connected to the second pulse output (SA2), that the output of the third AND-gate (U3) is connected to the first pulse output (SA1), that there is provided a second NOR-gate (NO2) whose inputs are connected to all outputs of the flip-flops (K1 to K5) of the shift register (SR), and that the output of the second NOR-gate (NO2) is connected to the second input of a fourth AND-gate (U4) whose first input is connected to the output of the first inverter (I), whose third input is connected to the fourth input (SE4) of the control unit (ST), whose fourth input is connected to the third input (SE3) of the control unit (ST) and whose output is connected to the reset input (R) of the control flip-flop (KA).

3. Circuit arrangement as claimed in claim 1, characterised in that in the case of a transmission rate of 32,000 code words per second, the first store (SP1) possesses a storage capacity of n = 4 bits for each information bit (VZ, 2nd to 11th bit) of a code word.

4. Circuit arrangement as claimed in one of the preceding claims, characterised in that there is provided a shift register (SR) having n+1 flip-flops.

5. Circuit arrangement as claimed in one of the preceding claims, characterised in that there is provided a four-stage binary counter (BZ).

6. Circuit arrangement as claimed in one of claims 1 to 3, characterised in that the three highest-level bits (2nd to 4th bit) are connected to the inputs of the first NOR-gate (NO1).

7. Circuit arrangement as claimed in one of the preceding claims, characterised in that the circuit arrangement is constructed in a monolithic integration technique.

**Revendications**

1. Circuit pour éviter des craquements lors de la transmission numérique d'un programme audio, caractérisé par le fait qu'il est prévu une première mémoire numérique (SP1) à plusieurs étages qui comporte n bascules par bit d'un mot-code (n = nombre des mots-code mémorisés temporairement) et à laquelle est appliqué en parallèle, par l'intermédiaire d'entrées de circuit, le mot-code numérique comprimé reçu (du premier bit au onzième bit), que les bits de poids fort (du deuxième au cinquième bit) du signal numérique reçu et le bit de signe (VZ) sont appliqués à un circuit de contrôle de parité (PP), que la première sortie (P1) de la première mémoire (SP1), sur laquelle est délivré le bit de signe, et les sorties (P6 à P11), sur lesquelles sont délivrés les bits de poids faible, sont reliées aux entrées (E22 à E27) d'une seconde mémoire (SP2) qui ne comporte qu'un élément de mémoire pour chaque bit, que les sorties de poids fort (P5 à P2) sont reliées aux entrées parallèles (V1 à V4) d'un compteur binaire dégressif (BZ) pouvant être préréglé, que les sorties (P21 à P27) de la seconde mémoire (SP2) et les sorties (Q1 à Q4) du compteur binaire (BZ) sont reliées à des points de raccordement (A1 à A11) qui correspondent aux entrées de circuit (E1 à E11) (A1 correspond à E1), que ces sorties (A1 à A11) sont reliées à un circuit expanseur, qu'il est prévu un circuit de commande (ST) dont l'entrée de cadence (SE1) est reliée à l'entrée de cadence (TS1) de la première mémoire (SP1), qu'une seconde entrée (SE2) du circuit de commande est reliée à la sortie (PA) du circuit de contrôle de parité (PP), que la sortie d'une porte $\overline{OU}$ (NO1), qui est reliée aux sorties de poids fort (P2 à P4) de la première mémoire (SP1), est reliée à une quatrième entrée (SE4) du circuit de commande (ST) et la sortie de report (Borrow — BA) du compteur binaire (BZ) est reliée à une troisième entrée (SE3) du circuit de commande (ST), qu'une première sortie de cadence (SA1) du circuit de commande (ST) est reliée à l'entrée de cadence (ST2) de la seconde mémoire (SP2) et à l'entrée de cadence de transfert (PE) du compteur binaire (BZ), et qu'une seconde sortie de cadence (SA2) du circuit de commande (ST) est reliée à l'entrée de cadence de comptage (BE) du compteur binaire (BZ).

2. Circuit suivant la revendication, caractérisé par le fait que le circuit de commande (ST) contient un registre à décalage (SR) qui est constitué par au moins autant de bascules (n) que sont prévus d'emplacements de mémoire (n) pour chaque bit dans la première mémoire (SP1), que l'entrée (SE2) du registre à décalage (SR) est reliée à la sortie (PA) du circuit de contrôle de parité (PP), que la cadence de mots (T0) est appliquée au registre à décalage (SR) par l'intermédiaire de l'entrée de cadence (SE1), que les sorties des bascules (K1 à K4) du registre à décalage (SR) sont reliées à un circuit logique à valeur de seuil (SL) qui délivre un signal d'erreur lorsqu'un mot code existe à la sortie de la première mémoire (SP1) et qu'il existe un signal d'erreur de parité sur au moins une autre entrée du circuit logique à valeur de seuil (SL), que la sortie du circuit logique à valeur de seuil (SL) est reliée à l'entrée de mise à l'état excité (S) d'une bascule de commande (KA) par l'intermédiaire d'une première porte ET (U1), que la seconde entrée de la première porte ET (U1) est reliée à l'entrée de cadence (SE1) par l'intermédiaire d'un premier inverseur (U1) que la sortie Q de la bascule de commande (KA) est reliée à une première entrée du seconde porte ET (U2) dont la seconde entrée est reliée à la troisième entrée (SE3) du circuit de commande (ST) par l'intermédiaire d'un second inverseur (I2) et dont la troisième entrée est reliée à une première d'une troisième porte ET (U3) et à l'entrée de cadence (SE1), que la sortie inverseuse ($\overline{Q}$) de la bascule de commande (KA) est reliée à une seconde entrée de la troisième porte ET (U3) dont la troisième entrée est reliée à la sortie inverseuse (Q̄) d'une bascule de type D (VK) qui sert d'élément de retard et dont l'entrée D est reliée à la sortie de nième bascule (K4) du registre à décalage (SR) et l'entrée de cadence est reliée à la sortie du premier inverseur (I1), que la sortie de la seconde porte ET (U2) est reliée à la seconde sortie de cadence (SA2), que la sortie de la troisième porte ET (U3) est reliée à la première sortie de cadence (SA1), qu'il est prévu une seconde porte OŪ (NO2) dont les entrées sont reliées à toutes les sorties des bascules (K1 à K5) du registre à décalage (SR), et que la sortie de la seconde porte OŪ (NO2) est reliée à la seconde entrée d'une quatrième porte ET (U4) dont la première entrée est reliée à la sortie du premier inverseur (I1), dont la troisième entrée est reliée à la quatrième entrée (SE4) du circuit de commande (ST), dont la quatrième entrée est reliée à la troisième entrée (SE3) du circuit de commande (ST), et dont la sortie est reliée à l'entrée de mise à l'état de repos (R) de la bascule de commande (KA).

3. Circuit suivant la revendication 1, caractérisé par le fait que dans le cas d'une vitesse de transmission de 32000 mots-code par seconde, la première mémoire (SP1) possède une capacité de mémoire de n = 4 bits par bit d'information (VZ, deuxième au onzième bit) d'un mot-code.

4. Circuit suivant l'une des revendications précédentes, caractérisé par le fait qu'il est prévu un registre à décalage (SR) qui comporte n + 1 bascules.

5. Circuit suivant l'une des revendications précédentes, caractérisé par le fait qu'il est prévu un compteur binaire (BZ) à quatre étages.

6. Circuit suivant l'une des revendications 1 à 3, caractérisé par le fait que les trois bits de poids fort (deuxième ou quatrième bit) sont appliqués aux entrées de la première porte OU (NO1).

7. Circuit suivant l'une des revendications précédentes, caractérisé par le fait que le circuit est réalisé suivant la technique d'intégration monolithique.

# FIG 1

# FIG 2

FIG 3